Europäisches Patentamt

European Patent Office

Office européen des brevets

(19)

(11) Numéro de publication: **0 131 493 B1**

(12) **FASCICULE DE BREVET EUROPEEN**

(45) Date de publication du fascicule du brevet:
26.08.87

(51) Int. Cl.⁴: **G 11 C 25/00,** G 09 F 9/37

(21) Numéro de dépôt: **84401252.6**

(22) Date de dépôt: **18.06.84**

(54) **Dispositif à commande électrique de déplacement de fluide.**

(30) Priorité: **30.06.83 FR 8310914**

(43) Date de publication de la demande:
**16.01.85 Bulletin 85/3**

(45) Mention de la délivrance du brevet:
**26.08.87 Bulletin 87/35**

(84) Etats contractants désignés:
**DE GB IT NL SE**

(56) Documents cités:
**WO - A - 80/00103**

**IBM TECHNICAL DISCLOSURE BULLETIN, volume 22, no. 1, juin 1979 (NEW YORK, US) N.H. RUNYAN: "Electrostatic liquid display devices", page 352
XEROX DISCLOSURE JOURNAL, volume 4, no. 3, mai/juin 1979 (NEW YORK, US) N.K. SHERIDON: "Electrocapillary imaging devices for display and data storage", pages 385-386**

(73) Titulaire: **THOMSON-CSF, 173, Boulevard Haussmann, F-75379 Paris Cedex 08 (FR)**

(72) Inventeur: **Le Pesant, Jean-Pierre, THOMSON-CSF SCPI 173, bld Haussmann, F-75379 Paris Cedex 08 (FR)**
Inventeur: **Hareng, Michel, THOMSON-CSF SCPI 173, bld Haussmann, F-75379 Paris Cedex 08 (FR)**
Inventeur: **Mourey, Bruno, THOMSON-CSF SCPI 173, bld Haussmann, F-75379 Paris Cedex 08 (FR)**
Inventeur: **Perbet, Jean-Noel, THOMSON-CSF SCPI 173, bld Haussmann, F-75379 Paris Cedex 08 (FR)**

(74) Mandataire: **Lepercque, Jean et al, THOMSON-CSF SCPI 19, avenue de Messine, F-75008 Paris (FR)**

## Description

La présente invention se rapporte aux dispositifs à commande électrique de déplacement de fluides comprenant un espace capillaire délimité par deux plaques de confinement porteuses de couples d'électrodes. Le remplissage partiel de cet espace permet de disposer d'une phase globulaire dont les éléments fluides peuvent évoluer au sein d'une phase lacunaire. L'évolution est commandée électriquement en appliquant des tensions électriques aux couples d'électrodes. Grâce à une différence de permittivité entre les deux phases fluides et aux gradients de champ électriques qui résultent des tensions appliquées, la polarisation électrique donne naissance à des forces volumiques permettant de déplacer les éléments fluides dans l'étendue du volume capillaire. Plus précisément, un globule fluide présentant une permittivité supérieure à son environnement sera attiré vers un couple d'électrodes siège d'une tension électrique. Par le jeu des forces de tension superficielles, ce globule tend à conserver son individualité et en admettant qu'il soit totalement libre, on peut se le représenter comme une goutte circulaire aplatie entre les deux plaques de confinement. L'étalement d'une telle goutte est constant dans le cas d'un espace capillaire de hauteur uniforme. Pour entraver le moins possible le déplacement d'un élément fluide, les faces de contact des plaques de confinement doivent offrir une faible mouillabilité que l'on obtient par un traitement approprié. Cependant, il peut être avantageux de mettre en œuvre des forces moléculaires dans les zones encadrées d'électrodes pour astreindre les globules à rester captifs même si la tension électrique de commande est annulée. Le passage d'un site de capture au site voisin nécessite une tension électrique transitoire permettant de vaincre les forces moléculaires qui jouent le rôle de forces de rappel. Les forces dont il vient d'être question sont toutes supérieures aux forces qui pourraient résulter d'une accélération subie par le dispositif, car les éléments fluides sont de taille suffisamment faible pour que les forces d'origine électrique ou moléculaire l'emportent sur les forces inertielles ou de gravitation.

La configuration donnée aux électrodes permet de concevoir le cheminement d'un ou plusieurs globules entre une zone réservoir et une zone collectrice. Dans l'étendue du volume capillaire, on peut prévoir un chemin matérialisé par un chapelet d'électrodes qui reçoivent des impulsions de tension grâce auxquelles un fluide à déplacer converge vers une zone à gradient de champ en chassant le fluide de moindre permittivité qui l'entoure. Ce mouvement peut se répéter de proche en proche en décalant dans le temps les impulsions de tension.

Le déplacement d'un fluide d'un couple d'électrodes au couple d'électrodes voisin pose le problème de l'agencement et de la forme donnée aux électrodes. En effet, la localisation du fluide en vue du maintien des positions acquises conduit à espacer les zones de capture pour s'opposer à un mélange intempestif des globules fluides qui ont tendance à s'agglutiner dès qu'ils peuvent se rencontrer. Lorsque les zones de capture sont confondues avec les zones équipées d'électrodes, cela conduit à éloigner les unes des autres les électrodes.

La commande électrique de déplacement est liée à l'interaction d'un gradient de champ électrique avec le globule de fluide à déplacer. En considérant deux sites voisins, on voit que le globule fluide occupant un des sites doit se trouver dans la zone d'influence du site voisin pour que l'effet d'attraction soit suffisamment intense. Ceci revient à rapprocher l'un de l'autre les couples d'électrodes ou à faire en sorte que chaque globule soit plus étendu que les électrodes assurant son maintien ou son déplacement. Avec les formes d'électrodes connues, il est difficile de concilier deux fonctions antagonistes qui sont de réaliser un maintien précis et d'obtenir une sollicitation électromécanique importante. L'utilisation d'électrodes de forme rectangulaire ou triangulaire ne réalise pas un compromis satisfaisant. En outre, pour imposer un sens de déplacement aux globules, il est nécessaire de faire appel à des séquences d'impulsions électriques relativement complexes.

L'invention vise à remédier aux inconvénients énumérés ci-dessus par l'utilisation d'électrodes à indentation. L'indentation assure une interpénétration des électrodes telle que le contour du fluide relaxé occupant une zone de capture soit coupé par l'indentation du couple d'électrodes définissant la zone de capture voisine. Le mode d'interpénétration des électrodes permet le cas échéant de privilégier un sens de déplacement.

L'invention a pour objet un dispositif à commande électrique de déplacement de fluide par globules fluides partageant avec un fluide non-miscible de permittivité diélectrique moindre, un espace capillaire ménagé entre deux plaques de confinement; les propriétés tensio-actives résultant de la constitution desdites plaques assurant le maintien desdits globules fluides le long d'au moins une voie de circulation appartenant audit espace; le déplacement desdits globules fluides le long de ladite voie étant assuré par les forces volumiques concentratrices créées par des couples d'électrodes agencés le long de ladite voie, lesdites électrodes étant portées par lesdites plaques de confinement et reliées à un générateur électrique de commande, caractérisé en ce que les électrodes de deux couples successifs ont en commun au moins une indentation.

L'invention sera mieux comprise au moyen de la description ci-après et des figures annexées parmi lesquelles:

la fig. 1 est une vue isométrique d'un dispositif à commande électrique de déplacement de fluide de type connu;

la fig. 2 est une vue partielle d'un agencement d'électrodes selon l'invention;

la fig. 3 est une vue illustrant une autre configuration d'électrodes selon l'invention;

la fig. 4 représente un agencement d'électrodes permettant de faire circuler un fluide de et vers des embranchements reliés à un tronc commun;

la fig. 5 représente un agencement d'électrodes permettant de faire circuler un fluide et de l'aiguiller selon les voies qui se séparent ou se rencontrent;

la fig. 6 représente une disposition d'électrodes permettant de fondre en un seul deux globules fluides incidents;

la fig. 7 représente une variante de réalisation des électrodes.

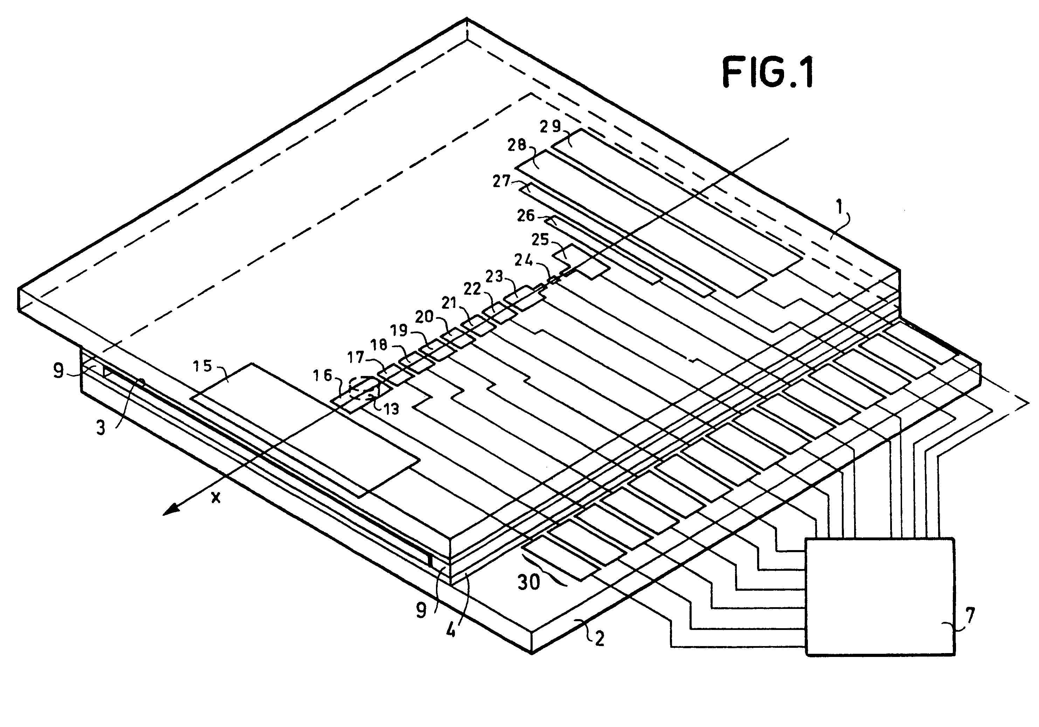

Sur la fig. 1, on peut voir un dispositif connu à commande électrique de déplacement de fluide. Un espace capillaire est délimité par deux plaques de confinement 1 et 2 avec interposition d'entretoises 9. Typiquement la hauteur de l'espace capillaire est de l'ordre de quelques dizaines de micron, ses deux autres dimensions étant beaucoup plus importantes pour définir un champ dans l'étendue duquel des globules fluides peuvent évoluer en disposant de deux degrés de liberté.

Le volume capillaire est partagé par au moins deux fluides non-miscibles de permittivités distinctes. L'un des fluides de remplissage présente une phase globulaire 13 et il est avantageusement constitué par un liquide présentant une permittivité élevée associée à une faible conductivité électrique. L'autre fluide de remplissage présente une phase lacunaire complètant le volume capillaire et il est avantageusement constitué par un gaz ou une vapeur, afin de favoriser son écoulement lors des déplacements des éléments 13 de la phase globulaire. Typiquement le fluide qui entoure un globule 13 est de l'air et le fluide constitutif du globule est un hydrocarbure liquide tel que la cyclohexanone. La quantité de liquide contenue dans un globule 13 est suffisante pour qu'il se présente sous la forme d'une goutte pincée entre les plaques de confinement 1 et 2. Les plaques 1 et 2 sont réalisées dans un matériau offrant une faible mouillabilité par rapport au liquide à déplacer dans le volume capillaire. Comme le montre la fig. 1, cette faible mouillabilité peut être obtenue par un revêtement interne des plaques 1 et 2 qui se présente sous la forme de dépôts extrêmement minces 3 et 4. A titre indicatif, ces dépôts 3 et 4 ont avantageusement une épaisseur de l'ordre du millimicron et peuvent être constitués d'organosilane tel que le N,N-diméthyle-N-octadécyle-3 amino-propyltriméthoxysilyl chlorure. Ce dépôt a été polymérisé sous azote à 110°C après hydrolyse des groupements méthoxysilane et formation par chemisorbtion sur le substrat de liaisons hydrogène et siloxane. Le but d'un tel traitement est d'améliorer la cohésion et la mobilité des globules liquides au sein du volume capillaire. La cohésion du globule liquide 13 est assurée par les forces de tension superficielle. A l'état relaxé, c'est-à-dire en l'absence d'autres forces, la forme du globule est celle d'un pion circulaire. En raison de la faible quantité de matière contenue dans un globule, les forces d'inertie ou de gravitation peuvent être négligées par rapport aux forces de tension superficielle.

Pour constituer un dispositif complet, la fig. 1 montre que les plaques 1 et 2 sont munies de couples d'électrodes. Pour la clarté du dessin, seules les électrodes inférieures de chaque couple sont représentées. Les électrodes 15, 16, 17, 18, 19, 20, 21, 22, 23, 24, 25, 26, 27, 28 et 29 ont été aménagées sur la plaque 2 avant d'y déposer la couche non mouillante 4. Ces électrodes sont reliées à des plots conducteurs marginaux 30 auxquels est raccordé un générateur 7 de tensions électriques impulsionnelles. Ainsi chaque électrode visible sur la fig. 1 représente l'armature inférieure d'un condensateur, l'autre armature portée par la plaque 1 étant constituée par une contre-électrode de même forme ou constituée par une contre-électrode commune. Indépendamment de leur fonction électrique, les électrodes 15 à 29 peuvent servir de moyen de capture vis-à-vis du globule liquide 13. En effet, les forces moléculaires peuvent agir sur le globule 13 à travers le dépôt non mouillant 4 pour lui assigner un site préférentiel à l'intérieur du contour de l'électrode. Le maintien en position d'un globule 13 est donc assuré par une force de rappel moléculaire qui dispense de l'application permanente d'une tension électrique pour fixer le globule dans une position déterminée. Bien entendu, cette force de rappel doit être vaincue par les forces volumiques de déplacement pour modifier la position du globule dans l'espace capillaire ainsi conditionné.

La fonction électrique des électrodes est de créer localement dans l'espace capillaire un gradient de champ électrique qui en association avec la polarisation électrique des fluides en présence produit des forces volumiques dont la résultante non nulle attire le globule 13 entre les armatures de chaque condensateur. Cette attraction est d'autant plus forte que le gradient de champ est intense et que les fluides en présence diffèrent en permittivité de chaque côté de l'interface qui les sépare (contour de globule). Dans le cas d'armatures de condensateur présentant un écartement faible par rapport aux dimensions transversales, le gradient de champ est élevé à proximité des bords. Il y a lieu d'adopter pour chaque globule une étendue voisine de celle des électrodes et à placer les couples d'électrodes proches l'un de l'autre pour bénéficier d'une force de déplacement appréciable. A titre d'exemple, sur la fig. 1, les électrodes 17 à 22 sont de forme sensiblement carrée ayant typiquement 0,5 mm de côté et la largeur des intervalles qui les séparent est typiquement de l'ordre de 20 μm. Elles sont par exemple constituées de dépôts d'oxyde d'indium et d'étain. Un tel dépôt est connu sous l'appellation «Baltracon», commercialisé par la société Balzers. Un recuit à 350°C assure la transparence à la lumière.

L'agencement d'électrodes visible sur la fig. 1 comporte une zone réservoir contrôlée par les électrodes 26 à 29, une zone d'injection fractionnée contrôlée par les électrodes 23 à 25, une zone de propagation contrôlée par les électrodes 17 à 22 et une zone collectrice contrôlée par les électrodes 15 et 16.

Lors du chargement en liquide du dispositif de la fig. 1, le générateur 7 fournit une tension électrique au couple d'électrodes 29, ce qui favorise sa progression dans l'espace capillaire. En mettant sous tension le couple d'électrodes 28, le liquide poursuit sa progression en occupant une région plus importante de l'espace capillaire, afin de constituer la réserve de fluide dont le fractionnement calibré fournit les globules 13 à déplacer. Cette progression de la nappe liquide vers la zone d'injection est obtenue en excitant successivement les couples d'électrodes 27 et 26. L'admission d'une quantité calibrée de liquide s'obtient par la mise sous tension des couples d'électrodes 25, 24, 23. A ce stade, les espaces interélectrodes 25, 24 et 23 ont capté du liquide au détriment de la zone réservoir. Lorsqu'on annule la tension d'excitation appliquée au couple d'électrodes 24, le liquide se fractionne dans cette région d'étranglement de sorte qu'il subsiste à l'intérieur du couple d'électrodes 23 un globule 13. La progression du globule 13 dans la zone de propagation s'obtient par mise sous tension du couple d'électrodes vers lequel on veut le déplacer et par abaissement ou annulation de la tension du couple d'électrodes qui le tenait captif. Le globule 13 termine sa course dans une zone collectrice où il est fusionné avec le liquide déjà présent.

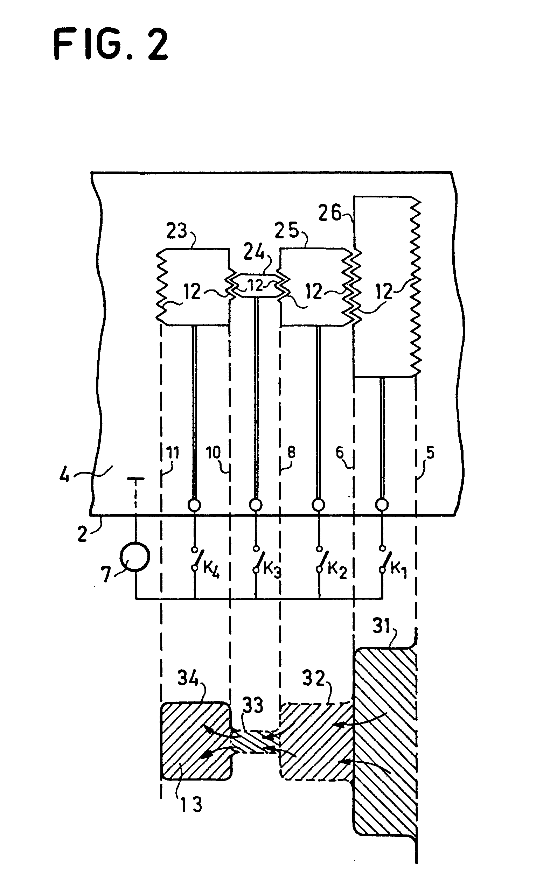

Le perfectionnement visé par l'invention consiste à donner aux électrodes un contour à indentation qui produit un empiètement d'un couple d'électrodes sur le couple voisin. Une telle disposition est représentée sur la fig. 2. Les mêmes références désignant les mêmes éléments que sur la fig. 1, on voit que les contours d'électrodes communs à deux couples voisins comportent un interstice 12 de forme ondulée, par exemple en dents de scie. Pour illustrer les commandes de tension, on a extrait du générateur 7 des moyens de commutation symbolisés par des interrupteurs $K_1$, $K_2$, $K_3$, $K_4$ alimentant respectivement les électrodes 26, 25, 24 et 23. Au bas de la fig. 2, on a représenté par des zones hachurées plusieurs stades d'évolution de la nappe liquide à déplacer; ces zones sont en fait situées à l'aplomb des électrodes 26 à 23, mais elles ont été illustrées distinctement en les rapportant aux électrodes concernées par les lignes de rappel 5 à 11.

Au départ, on suppose qu'une tension électrique est disponible aux bornes du générateur 7 et que l'on vient de fermer l'interrupteur $K_1$, les interrupteurs $K_2$ à $K_4$ étant provisoirement ouverts. Le liquide occupe alors la zone 31. Si l'on ouvre l'interrupteur $K_1$, le liquide reste sous l'emprise des forces moléculaires et à condition d'adopter des indentations 12 suffisamment rapprochées, on constate que le front du liquide épouse un contour sensiblement rectiligne dans le prolongement de la ligne 6. Grâce à une indentation d'amplitude supérieure à la largeur de l'espace interélectrode, on voit que les indentations 12 de l'électrode 25 empiètent sur le front gauche de la zone 31. Ainsi, en fermant l'interrupteur $K_2$ le liquide

subit plus fortement le gradient de champ créé par l'électrode 25; il se trouve attiré plus aisément comme le montrent les flèches incurvées et vient remplir la zone 32. L'ouverture de l'interrupteur $K_2$ amène le front du liquide le long de la ligne 8. La fermeture de l'interrupteur $K_3$ entraîne l'appel du liquide dans la zone 33 et celle de l'interrupteur $K_4$ le fera occuper la zone 34. La progression de droite à gauche, c'est-à-dire d'amont en aval, telle que décrite peut aussi se produire en cas de relaxation incomplète du liquide. Cela revient à laisser subsister une tension résiduelle sur les électrodes situées en amont de l'électrode qui vient d'être mise sous tension. Dans le cas d'un fractionnement, on ouvre l'interrupteur $K_3$ en laissant fermés les interrupteurs $K_2$ et $K_4$, ce qui force le liquide à refluer vers les régions 32 et 34 en quittant la zone 33.

Pour résumer ce qui précède, on voit que lorsqu'on réduit ou qu'on coupe le champ électrique localement, le liquide relaxe vers un volume dont l'étendue rapportée aux surfaces de confinement à un périmètre plus faible. Le pas et la longueur des indentations sont déterminées de sorte que, après cette relaxation, le volume du liquide à déplacer coupe les indentations du couple d'électrodes adjacent que l'on met alors sous tension. Cette configuration d'électrodes permet d'améliorer le déplacement de fluide dans n'importe quelle partie d'un agencement d'électrodes tel que représenté sur la fig. 1. En outre, comme il s'agit d'indentations multiples ondulantes, l'effet est le même que le déplacement ait lieu dans un sens ou dans l'autre. Le sens de déplacement est fonction du séquencement des tensions de commande.

Il entre également dans le cadre de l'invention d'adopter une forme d'électrode à indentation qui fixe le sens d'un déplacement et simplifie les formes de signaux électriques à prévoir pour faire progresser pas à pas un globule liquide 13.

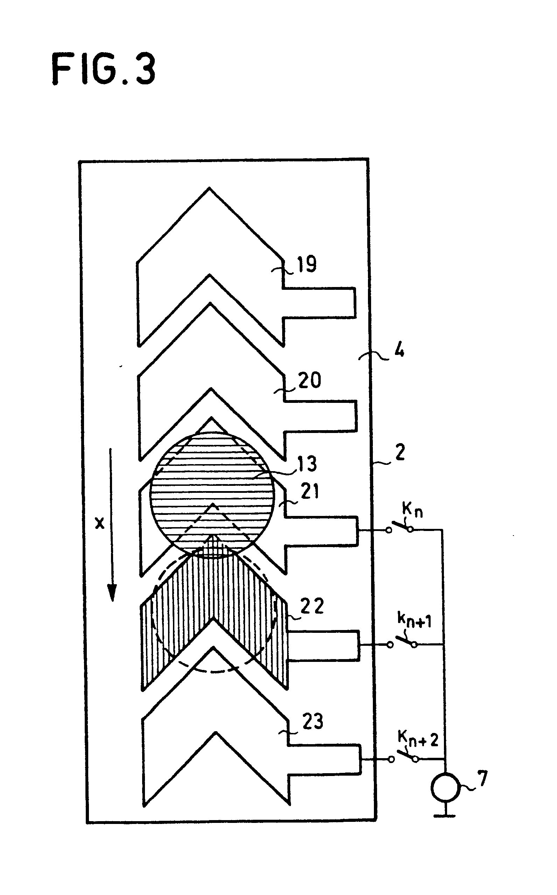

La fig. 3 illustre un premier exemple d'une telle disposition avec sa forme et son agencement. Les mêmes références désignant les éléments correspondants de la fig. 1, on voit que la forme donnée sur la fig. 3 aux couples d'électrodes 19 à 23 comporte des parties convexes qui s'emboîtent avec des parties concaves. Typiquement, les électrodes sont en forme de chevrons pointant dans la direction opposée à la direction X. Des effets similaires seraient obtenus avec des électrodes, par exemple en forme de croissants, de chevrons à ailes triangulaires ou de simples segments cintrés.

Comme le montre la fig. 3, on est encore en présence d'un agencement à indentation. Le globule 13 représenté à l'état relaxé au site d'occupation défini par le couple d'électrodes 21 présente une étendue voisine de l'aire des électrodes en chevron. Cette situation relaxée se présente lorsque les interrupteurs $K_n$, $K_{n+1}$ et $K_{n+2}$ qui matérialisent avec le générateur 7 la commande électrique de déplacement sont ouverts. Le globule 13 tend à se centrer au barycentre de l'électrode 21 et son contour circulaire est en prise avec la pointe du couple d'électrodes 22. Si l'on ferme l'interrupteur $K_n$, le liquide contenu dans le globule 13 se concentre entre les électrodes 21 en épousant leur forme; il retrouve sa forme primitive à l'ouverture de l'interrupteur $K_n$. Avec une tension électrique simplement réduite, il peut prendre une forme intermédiaire. Pour déplacer le globule 13 vers le couple d'électrodes 22, on ferme l'interrupteur $K_{n+1}$, ce qui a pour effet de concentrer le liquide sous l'électrode 22. La tension électrique nécessaire pour produire ce déplacement est abaissée grâce à la pointe de l'électrode 22 qui recouvre partiellement l'étendue du globule à déplacer. Si cette tension était appliquée à l'électrode 20 pour faire rétrograder le globule 13, il faudrait l'augmenter sensiblement, car l'électrode 20 n'a aucune prise sur le globule 13. Ainsi, en adoptant une valeur de tension juste suffisante pour produire le déplacement selon la direction X, on assure par la forme des électrodes un sens unique de progression. En rouvrant l'interrupteur $K_{n+1}$, le globule a avancé d'un pas et retrouve sa forme circulaire (contour en pointillé). On constate que la relaxation de périmètre du liquide à déplacer conjuguée avec une géométrie d'électrode comportant au moins une indentation amène le volume de liquide à quitter un site de capture pour un autre site de capture contrôlé par un autre couple d'électrodes dont il subira l'influence de façon préférentielle lors du cycle suivant de mise sous tension. Si l'on relie les électrodes de rang impair à une ligne excitatrice et les électrodes de rang pair à une autre ligne excitatrice, on peut faire avancer le globule pas à pas en appliquant la tension de commande alternativement aux deux lignes excitatrices. Une seule ligne excitatrice est même suffisante si la géométrie est telle que les gouttes ne se coupent pas dans leur forme relaxée et si les déplacements de toutes les gouttes d'une colonne telle que celle représentée sur la fig. 3 sont identiques et synchrones.

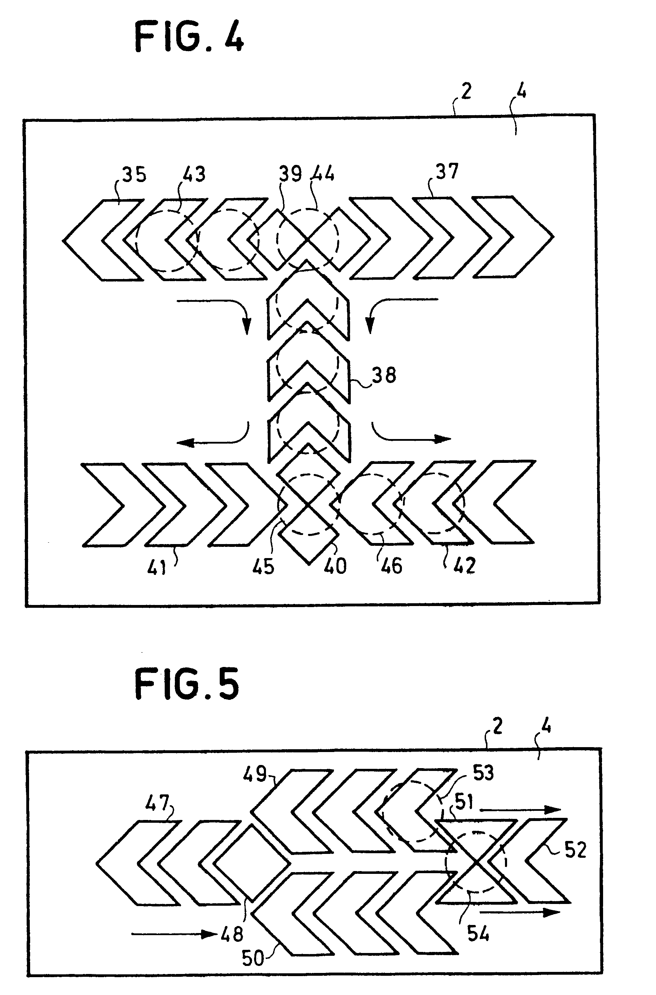

Sur la fig. 4, on peut voir un agencement de couples d'électrodes permettant de faire converger vers un tronc commun des globules liquides disponibles sur des voies latérales et de les faire diverger vers d'autres voies latérales en ayant le choix de la direction. Les voies d'accès gauche et droite sont matérialisées par des couples d'électrodes en chevrons 35 et 37. Ces voies permettent la circulation de globules fluides 43 vers un embranchement matérialisé par un couple d'électrodes 39 ayant une indentation avec chacun des chevrons 35 et 37 les plus proches. Le tronc commun est constitué de chevrons 38 dont le premier forme une indentation avec l'électrode 39. Les voies de sortie gauche et droite sont également formées de couples d'électrodes en chevrons 41 et 42 reliées au tronc commun par une électrode 40 de forme similaire à l'électrode 39. Par des tensions électriques appliquées à différents couples d'électrodes, on peut faire progresser le globule 43 jusqu'à ce qu'il vienne occuper la position 44. On peut ensuite lui faire franchir le tronc commun pour l'amener dans la position 45 et enfin le faire progresser à droite dans la position 46.

La fig. 5 représente un autre agencement comportant deux aiguillages. Une voie d'accès est matérialisée par des chevrons 47 et se termine par une électrode 48 permettant son raccordement avec deux voies secondaires matérialisées par des chevrons 49 et 50. Les voies secondaires sont reliées à une voie de sortie 52 par une électrode 51. Un globule liquide présent dans la voie d'accès 47 peut être aiguillé sur l'une des voies secondaires 49 ou 50 pour atteindre la position 53. Pour le ramener sur la voie de sortie 52, on lui fait prendre la position 54.

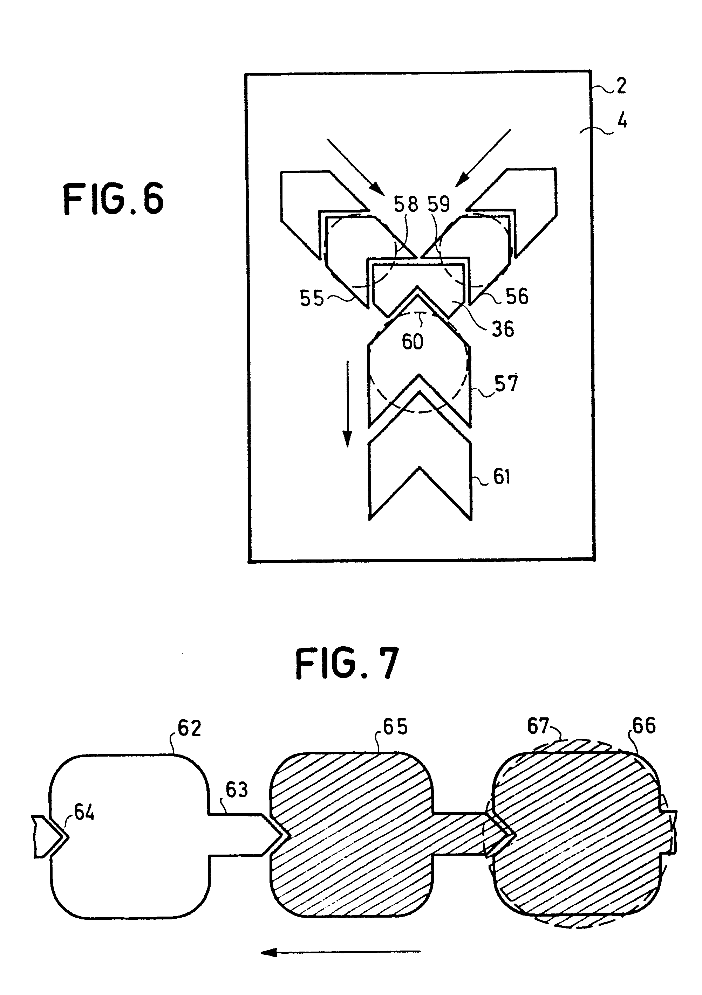

Sur la fig. 6, on peut voir un agencement étoilé de couples d'électrodes en chevrons. Des globules liquides 58 et 59 de volumes égaux ou inégaux progressent vers un site nodal occupé par un couple d'électrodes 36. Les voies d'amenée sont équipées d'électrodes en chevrons 55 et 56 dont la surface correspond sensiblement à l'étendue du globule 58 ou 59 à déplacer. La fusion des globules donne naissance à un globule 60 de taille supérieure qui peut emprunter la voie de sortie délimitée par des couples d'électrodes en chevrons 57, 61 ayant des dimensions adaptées à la taille du globule fusionné 60.

Les formes d'électrodes décrites précédemment comportent une indentation dans laquelle vient s'insérer une partie convexe du contour d'électrode. La méthode consiste à utiliser une forme d'électrode qui entraîne une contrainte de forme du globule de fluide lorsque celui-ci est soumis au champ électrique de polarisation, contrainte telle qu'elle ne corresponde pas à l'état d'équilibre relaxé. Lorsqu'on diminue ou que l'on supprime le champ de polarisation, le globule de fluide relaxe vers une forme moins contrainte, correspondant à une énergie de tension superficielle plus faible, dont le périmètre de section par les surfaces de confinement de l'espace capillaire est plus faible. Ceci entraîne l'occupation par le fluide des zones qui jouxtent les portions convexes des électrodes accompagnée d'un retrait des régions les plus éloignées du sommet de la partie convexe. On voit en effet sur la fig. 3 qu'en se relaxant le globule 13 déborde de la partie convexe de l'électrode 21 en se retirant de ses régions pointues. En se comblant, le milieu de la partie concave permet l'empiètement du globule relaxé sur la pointe de la partie convexe de l'électrode suivante 22.

Pour disposer d'un meilleur espacement des électrodes, on voit sur la fig. 7 qu'il est possible de conserver aux électrodes 62, 65 et 66 une forme générale assez proche de celle du globule liquide relaxé 67. L'électrode présente par exemple une forme carrée à coins arrondis avec une indentation 64 en forme de Vé. Pour assurer un déplacement aisé du globule, chaque électrode est munie d'un appendice 63 dont l'extrémité pointue vient prendre place dans l'indentation en Vé de l'électrode précédente. Le déplacement du globule 67 dans la direction de la flèche s'obtient à partir du couple d'électrodes 66 par relaxation du champ électrique créé à son niveau et par mise sous tension du couple voisin 65. Le liquide sollicité électriquement par l'extrémité de l'appendice de l'électrode 65 va s'écouler via cet appendice pour s'étaler à l'intérieur de ce couple voisin d'électrodes 65.

Un avantage significatif de la forme d'électrode illustrée à la fig. 7 est de permettre de réaliser des déplacements de globules bilatéraux ou à angle droit. On peut en effet prévoir entre les électrodes 65 et 66 un deuxième appendice qui serait solidaire de l'électrode 66 et dont la pointe viendrait s'emboîter dans une indentation en Vé de l'électrode 65. On peut également prévoir des appendices ou indentations sur les côtés des électrodes qui en sont dépourvues sur la fig. 7, ceci afin de permettre des déplacements de globules perpendiculairement à la direction de la flèche. Le chapelet d'électrodes représenté sur la fig. 7 peut en effet constituer une ligne d'un agencement matriciel où des électrodes agencées en colonne sont susceptibles d'échanger des globules. La forme générale quasi carrée des électrodes de la fig. 7 est mieux adaptée que celle en chevrons à des déplacements organisés en deux dimensions. Par contre, la forme en chevrons peut également bénéficier d'un appendice placé en tête de la partie convexe. Une telle forme d'électrode serait proche de celle d'une étoile à trois branches et l'agencement serait tel qu'une branche d'une électrode s'étende dans le secteur délimité par deux branches de l'électrode voisine.

## Revendications

1. Dispositif à commande électrique de déplacement de fluide par globules fluides partageant avec un fluide non-miscible de permittivité diélectrique moindre, un espace capillaire ménagé entre deux plaques de confinement; les propriétés tensio-actives résultant de la constitution desdites plaques assurant le maintien desdits globules fluides le long d'au moins une voie de circulation appartenant audit espace; le déplacement desdits globules fluides le long de ladite voie étant assuré par les forces volumiques concentratrices créées par des couples d'électrodes agencés le long de ladite voie, lesdites électrodes étant portées par lesdites plaques de confinement et reliées à un générateur électrique de commande, caractérisé en ce que les électrodes (19, 20, 21, 22, 23, 24, 25, 26, 35, 36, 37, 38, 39, 40, 41, 42, 47, 48, 49, 50, 51, 52, 55, 56, 57, 61, 62, 65, 66) de deux couples successifs dans la direction de propagation ont en commun au moins une indentation (12, 64).

2. Dispositif selon la revendication 1, caractérisé en ce que l'indentation commune à deux électrodes délimite entre celles-ci (23, 24, 25, 26) un interstice de forme sinueuse (12).

3. Dispositif selon la revendication 2, caractérisé en ce que l'interstice présente une forme en dents de scie (12).

4. Dispositif selon la revendication 1, caractérisé en ce que lesdites électrodes (19, 20, 21, 22, 23, 35, 37, 38, 41, 42, 47, 49, 50, 52, 55, 56, 57, 61) ont un contour présentant une partie convexe et une partie concave s'emboîtant les unes les autres de proche en proche pour former une voie de circulation.

5. Dispositif selon la revendication 4, caractérisé en ce que ledit contour épouse la forme d'un chevron.

6. Dispositif selon la revendication 4, caractérisé en ce que l'étendue délimitée par ledit contour correspond sensiblement à l'étendue desdits globules fluides (13, 60).

7. Dispositif selon la revendication 1, caractérisé en ce que deux électrodes successives (62, 65, 66) présentent, l'une (66) au moins une indentation périphérique concave (64), l'autre (65) au moins un appendice (63) dont l'extrémité convexe s'emboîte dans ladite indentation périphérique concave (64).

8. Dispositif selon l'une quelconque des revendications précédentes, caractérisé en ce que lesdites électrodes (35, 37, 38, 39, 40, 41, 42) sont agencées selon un tronc principal et des embranchements.

9. Dispositif selon l'une quelconque des revendications 1 à 7, caractérisé en ce que lesdites électrodes (47, 48, 49, 50, 51, 52) sont agencées pour former un aiguillage.

10. Dispositif selon l'une quelconque des revendications 1 à 7, caractérisé en ce que lesdites électrodes (55, 36, 56, 57, 61) sont agencées suivant des voies en étoile permettant de réaliser la fusion de deux globules (58, 59) en un seul (60).

11. Dispositif selon l'une quelconque des revendications 1 à 7, caractérisé en ce que lesdites électrodes sont agencées pour former une zone réservoir (26, 27, 28, 29), une zone d'injection fractionnée (23, 24, 25), une zone de propagation (17, 18, 19, 20, 21, 22) ou une zone collectrice (15, 16).

## Patentansprüche

1. Vorrichtung mit elektrischer Steuerung zur Verschiebung eines Fluids durch flüssige Kugeln, welche mit einem nicht mischbaren Fluid mit geringerer Dielektrizitätskonstante einen zwischen zwei Einschlussplatten eingerichteten Kapillarraum teilen, wobei die aus der Anordnung der genannten Platten resultierenden kapillaraktiven Eigenschaften für die Führung der genannten flüssigen Kugeln längs zumindest einer der dem genannten Raum angehörenden Bahnen sorgen, wobei die Verschiebung der genannten flüssigen Kugeln längs der genannten Bahn durch die konzentrierenden volumenbezogenen Kräfte bewirkt wird, welche durch längs der genannten Bahn angebrachte Elektrodenpaare hervorgerufen werden, wobei die genannten Elektroden von den genannten Einschlussplatten getragen werden und an einen Steuergenerator angeschlossen sind, dadurch gekennzeichnet, dass den Elektroden (19, 20, 21, 22, 23, 24, 25, 26, 35, 36, 37, 38, 39, 40, 41, 42, 47, 48, 49, 50, 51, 52, 55, 56, 57, 61, 62, 65, 66) von zwei aufeinanderfolgenden Paaren in der Ausbreitungsrichtung mindestens eine Auszahnung (12, 64) gemeinsam ist.

2. Vorrichtung gemäss Anspruch 1, dadurch gekennzeichnet, dass die den beiden Elektroden gemeinsame Verzahnung zwischen diesen Elektroden (23, 24, 25, 26) einen kurvenförmigen Spalt (12) abgrenzt.

3. Vorrichtung gemäss Anspruch 2, dadurch gekennzeichnet, dass der Spalt eine gezackte Form (12) aufweist.

4. Vorrichtung gemäss Anspruch 1, dadurch gekennzeichnet, dass die genannten Elektroden (19, 20, 21, 22, 23, 35, 37, 38, 41, 42, 47, 49, 50, 52, 55, 56, 57, 61) eine Kontur besitzen, die je einen konvexen und einen konkaven Teil aufweist, die sich nach und nach ineinanderschieben, um eine Bahn zu bilden.

5. Vorrichtung gemäss Anspruch 4, dadurch gekennzeichnet, dass die genannte Kontur die Form eines Zick-Zack-Körpers annimmt.

6. Vorrichtung gemäss Anspruch 4, dadurch gekennzeichnet, dass der durch die genannte Kontur abgegrenzte Bereich etwa dem Umfang der flüssigen Kugeln (13, 60) entspricht.

7. Vorrichtung gemäss Anspruch 1, dadurch gekennzeichnet, dass von zwei aufeinanderfolgenden Elektroden (62, 65, 66) eine (66) wenigstens eine konkave periphere Auszahnung (64) und die andere (65) wenigstens einen Ansatz (63) aufweist, dessen konvexes Ende sich in die genannte konkave periphere Auszahnung (64) schiebt.

8. Vorrichtung gemäss einem der vorausgegangenen Ansprüche, dadurch gekennzeichnet, dass die genannten Elektroden (35, 37, 38, 39, 40, 41, 42) entsprechend einem Hauptstamm mit Verzweigungen angeordnet sind.

9. Vorrichtung gemäss einem der Ansprüche 1 bis 7, dadurch gekennzeichnet, dass die genannten Elektroden (47, 48, 49, 50, 51, 52) so angeordnet sind, dass sie eine Weiche bilden.

10. Vorrichtung gemäss einem der Ansprüche 1 bis 7, dadurch gekennzeichnet, dass die genannten Elektroden (55, 36, 56, 57, 61) in sternförmigen Bahnen angeordnet sind, wodurch die Verschmelzung der beiden Kugeln (58, 59) in eine einzige Kugel (60) erreicht werden kann.

11. Vorrichtung gemäss einem der Ansprüche 1 bis 7, dadurch gekennzeichnet, dass die genannten Elektroden so angeordnet sind, dass eine Vorratszone (26, 27, 28, 29), eine Zone für die fraktionierte Einspritzung (23, 24, 25), eine Ausbreitungszone (17, 18, 19, 20, 21, 22) oder eine Auffangzone (15, 16) gebildet werden.

**Claims**

1. Electrically controlled device for moving a fluid by fluid globules sharing with an immiscible fluid of lesser dielectric permittivity a capillary space existing between two plates confining the fluid; the voltage-active properties resulting from the construction of the said plates ensuring the maintenance of the said fluid globules along at least one path of circulation belonging to the third space; the movement of the said fluid globules along the said path being ensured by the concentrative body forces created by electrodes placed along the said path, the said electrode being carried by the said confinement plates and connected to an electric control generator, wherein the said electrodes (19, 20, 21, 22, 23, 24, 25, 26, 35, 36, 37, 38, 39, 40, 41, 42, 47, 48, 49, 50, 51, 52, 55, 56, 57, 61, 62, 65, 66), of two successive pairs in the direction of propagation have at least one indentation (12, 64) in a common.

2. Device as claimed in claim 1, wherein the indentation common to two electrodes delimits an interstices of a sinuous form (12) between these electrodes (23, 24, 25, 26).

3. Device as claimed in claim 2, wherein the interstices has a sawtooth shape (12).

4. Device as claimed in claim 1, wherein the said electrodes (19, 20, 21, 22, 23, 35, 37, 38, 41, 42, 47, 49, 50, 52, 55, 56, 57, 61) have a contour with a convex part and a concave part fitting into one another to form a path of circulation.

5. Device as claimed in claim 4, wherein the said contour follows the shape of a chevron.

6. Device as claimed in claim 4, wherein the area delimited by the said contour roughly corresponds to the area of the said fluid globules (13, 60).

7. Device as claimed in claim 1, wherein two electrodes in succession (62, 65, 66) have at least one concave peripheral indentation (64) on one of them (66) and at least one one appendage (63) on the other (65), the convex extremity of which fits into the said concave peripheral indentation (64).

8. Device as claimed in any other previous claim, wherein the said electrodes (35, 37, 38, 39, 40, 41, 42) are arranged in a main trunk with branch connection.

9. Device as claimed in any of the claims 1 to 7, wherein the said electrodes (47, 48, 49, 50, 51, 52) are arranged to make a switch.

10. Device according to any claim 1 to 7, wherein the said electrodes (55, 36, 56, 57, 61) are arranged in a star pattern of paths to merge two globules (58, 59) into a single one (60).

11. Device as claimed in any claim from 1 to 7, wherein the said electrodes are arranged to form one reservoir area (26, 27, 28, 29), one split injection area (23, 24, 25), one propagation area (17, 18, 19, 20, 21, 22) or one collector area (15, 16).

FIG.1

# FIG. 2

# FIG.3

# FIG. 4

# FIG.5

FIG.6

FIG. 7